(19) Europäisches Patentamt
European Patent Office
Office européen des brevets

(11) **EP 2 401 623 B1**

(12) **FASCICULE DE BREVET EUROPEEN**

(45) Date de publication et mention
de la délivrance du brevet:
**25.06.2014 Bulletin 2014/26**

(21) Numéro de dépôt: **10704376.2**

(22) Date de dépôt: **22.02.2010**

(51) Int Cl.:
*G01R 31/36* (2006.01)     *H01M 8/04* (2006.01)

(86) Numéro de dépôt international:
**PCT/EP2010/052175**

(87) Numéro de publication internationale:
**WO 2010/097354 (02.09.2010 Gazette 2010/35)**

(54) **PROCÉDÉ DE CARACTÉRISATION D'UN SYSTÈME ÉLECTRIQUE PAR SPECTROSCOPIE D'IMPÉDANCE**

VERFAHREN ZUM CHARAKTERISIEREN EINES ELEKTRISCHEN SYSTEMS DURCH IMPEDANZSPEKTROSKOPIE

METHOD OF CHARACTERIZING AN ELECTRICAL SYSTEM BY IMPEDANCE SPECTROSCOPY

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **24.02.2009 FR 0951165**

(43) Date de publication de la demande:
**04.01.2012 Bulletin 2012/01**

(73) Titulaires:
• **Helion**
**13545 Aix en Provence Cedex 4 (FR)**
• **Institut National Polytechnique De Toulouse (INPT)**
**31029 Toulouse Cedex 4 (FR)**
• **Centre National de la Recherche Scientifique**
**75016 Paris (FR)**
• **Phlippoteau, Vincent**
**31000 Toulouse (FR)**

(72) Inventeurs:
• **TURPIN, Christophe**
**F-31100 Toulouse (FR)**
• **RAKOTONDRAINIBE, André**
**F-13045 Aix-en-Provence (FR)**

(74) Mandataire: **Ilgart, Jean-Christophe et al**
**BREVALEX**
**95, rue d'Amsterdam**
**75378 Paris Cedex 8 (FR)**

(56) Documents cités:
• **YUAN ET AL: "AC impedance technique in PEM fuel cell diagnosis-A review" INTERNATIONAL JOURNAL OF HYDROGEN ENERGY, ELSEVIER SCIENCE PUBLISHERS B.V., BARKING, GB, vol. 32, no. 17, 29 novembre 2007 (2007-11-29), pages 4365-4380, XP022369437 ISSN: 0360-3199**
• **RODRIGUES S ET AL: "A review of state-of-charge indication of batteries by means of a.c. impedance measurements" JOURNAL OF POWER SOURCES, ELSEVIER SA, CH, vol. 87, no. 1-2, 1 avril 2000 (2000-04-01), pages 12-20, XP004194179 ISSN: 0378-7753**
• **HUET ET AL: "A review of impedance measurements for determination of the state-of-charge or state-of-health of secondary batteries" JOURNAL OF POWER SOURCES, ELSEVIER SA, CH, vol. 70, no. 1, 30 janvier 1998 (1998-01-30), pages 59-69, XP005907566 ISSN: 0378-7753**

**Description**

**DOMAINE TECHNIQUE**

La présente invention se rapporte au domaine général des systèmes électriques, et concerne plus spécialement un procédé de caractérisation dudit système électrique par spectroscopie d'impédance.

Le système électrique peut être un dispositif électrochimique, tel qu'une pile à combustible, un électrolyseur, une batterie primaire ou rechargeable, voire tout autre type de système électrique.

**ÉTAT DE LA TECHNIQUE ANTÉRIEURE**

La spectroscopie d'impédance est une technique de caractérisation utilisée dans de nombreux domaines techniques.

A titre illustratif, la spectroscopie d'impédance est utilisée dans les domaines de la corrosion, par exemple pour estimer le taux de corrosion d'une pièce métallique, de l'électrodéposition, ou encore de la détermination d'un état de santé d'un dispositif électrochimique comme une pile à combustible.

Dans ce dernier cas, la technique de la spectroscopie d'impédance peut être utilisée pour détecter l'engorgement et l'assèchement d'une pile à combustible, ainsi que le décrit l'article de Fouquet et al. intitulé « Model based PEM fuel cell state-of-health monitoring via ac impedance measurements » et publié en 2006 dans Journal of Power Sources, 159, 905-913.

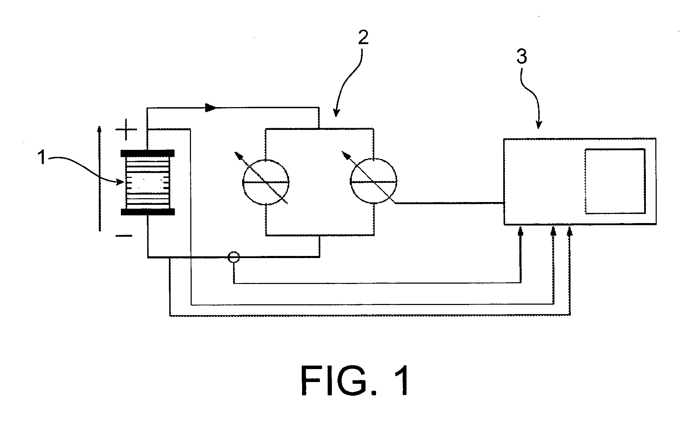

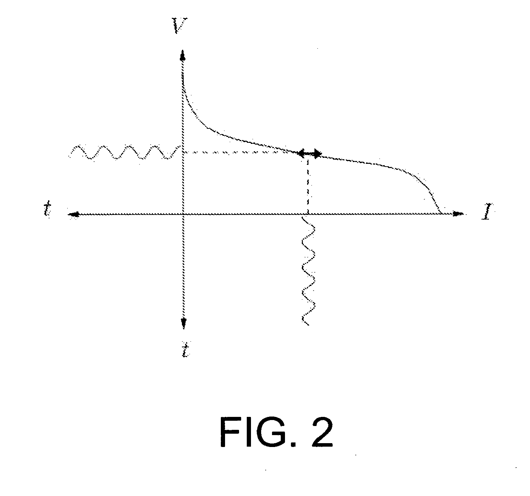

Comme représenté sur la figure 1, un courant ie est appliqué à la pile 1, qui présente une séquence de perturbations sinusoïdales autour d'un point de polarisation (figure 2). Le courant ie est appliqué par une charge active 2 délivrant un courant continu auquel sont superposées lesdites perturbations. La fréquence de celles-ci est commandée par un dispositif d'analyse d'impédance 3. Les perturbations présentent une faible amplitude et balayent une large gamme de fréquences.

La tension en réponse à ces perturbations est mesurée aux bornes de la pile. L'analyseur d'impédance 3 donne l'évolution dans le plan de Nyquist de la partie imaginaire de l'impédance en fonction de sa partie réelle.

Les perturbations sont classiquement appliquées de manière à balayer une large gamme de fréquences, en allant des hautes fréquences jusqu'aux basses fréquences, les fréquences étant espacées de façon logarithmique. La gamme de fréquences peut aller de quelques millihertz à quelques dizaines de kilohertz.

Ainsi, la partie des hautes fréquences est balayée très rapidement, alors que pour les basses fréquences, le temps de mesure devient non négligeable. Par exemple, une seconde suffit pour passer de 10kHz à 500Hz avec environ cent points par décade, alors que plusieurs minutes sont nécessaires pour les mesures de fréquences inférieures à 1Hz.

L'exploitation des données expérimentales nécessite que la pile reste stable le temps de l'application desdites perturbations, c'est-à-dire que la valeur moyenne du courant de polarisation et celle de la tension de réponse restent constantes dans le temps.

Or, cette hypothèse peut ne pas être vérifiée, notamment lors de dégradations ou défaillances momentanées du système électrique. A titre d'exemple, l'assèchement et l'engorgement d'une pile à combustible de type PEM rendent instable la pile, ce qui rend impossible l'exploitation de la mesure de l'impédance.

L'article de X. Yuan et al. intitulé « AC Impedance technique in PEM fuel cell diagnoses- A review » publié dans la revue International Journal of Hydrogen Energy, Vo. 32, 2007, pages 4365-4380, décrit un procédé de caractérisation d'une pile à combustible de type PEM, par spectroscopie d'impédance en appliquant une séquence de perturbations sinusoïdales selon un balayage d'une gamme de fréquences.

La technique actuelle de spectroscopie d'impédance présente l'inconvénient de ne pas permettre d'identifier directement, pendant le balayage de la gamme de fréquences, un changement dans la condition de stabilité du système électrique.

**EXPOSÉ DE L'INVENTION**

Le but de la présente invention est de proposer un procédé de caractérisation d'un système électrique par spectroscopie d'impédance, permettant de vérifier simplement et rapidement la stabilité dudit système, pendant le balayage de la gamme de fréquences.

Pour ce faire, l'invention a pour objet un procédé de caractérisation d'un système électrique comportant les étapes consistant à :

- appliquer audit système électrique un signal d'entrée comportant une séquence de perturbations sinusoïdales de courant ou de tension, autour d'un point de polarisation dudit système électrique, chaque perturbation ayant une fréquence différente appartenant à une suite principale de fréquences ;

- mesurer un signal de sortie dudit système électrique en réponse audit signal d'entrée pour chacune desdites perturbations appliquées ;
- estimer une grandeur caractéristique de l'impédance dudit système électrique pour chacune desdites perturbations appliquées, l'ensemble desdites estimations de la grandeur caractéristique de l'impédance caractérisant ledit système électrique.

Selon l'invention, les perturbations de ladite séquence sont appliquées de manière à balayer tour à tour une pluralité de sous-suites de fréquences issues de ladite suite principale, chacune desdites sous-suites ($A^1$, ..., $A^n$) étant un ensemble de fréquences issues de la suite principale (A), l'intersection desdites sous-suites étant égale à l'ensemble vide, chaque sous-suite de ladite pluralité étant entrelacée avec au moins une autre sous-suite de la même pluralité, de sorte qu'elle comporte au moins une fréquence comprise entre deux fréquences consécutives de ladite autre sous-suite avec laquelle elle est entrelacée.

Ainsi, le fait que les sous-suites de fréquences soient entrelacées revient à former une zone de recouvrement entre deux sous-suites considérées, voisines ou non l'une de l'autre. Une discontinuité dans les valeurs de l'impédance située dans cette zone de recouvrement met directement en évidence l'instabilité du système électrique étudié. La condition de stabilité du système électrique peut donc être vérifiée simplement et rapidement, pendant le balayage de la suite de fréquences déterminée.

De préférence, chaque sous-suite de ladite pluralité est entrelacée avec toutes les autres sous-suites de la même pluralité.

Les perturbations de ladite séquence sont appliquées de manière à balayer de manière monotone ou aléatoire les fréquences de chaque sous-suite.

Les perturbations de ladite séquence sont appliquées de manière à balayer de manière monotone, ou aléatoire, lesdites sous-suites de fréquences de ladite pluralité.

Ledit système électrique peut être tout dispositif électrochimique, comme, par exemple, un électrolyseur ou une pile à combustible.

L'invention porte également sur un procédé de commande d'un système électrique tel que défini en revendication 9,

D'autres avantages et caractéristiques de l'invention apparaîtront dans la description détaillée non limitative ci-dessous.

## BRÈVE DESCRIPTION DES DESSINS

On décrira à présent, à titre d'exemples non limitatifs, des modes de réalisation de l'invention, en se référant aux dessins annexés, parmi lesquels :

La figure 1, déjà décrite, est une représentation schématique d'une pile à combustible connectée à une source de courant et à un analyseur d'impédance ;
La figure 2, déjà décrite, est un graphe représentant l'application d'une perturbation en courant à la pile à combustible de la figure 1, autour d'un point de polarisation ;
Les figures 3A et 3B sont des graphes représentant l'évolution de l'impédance en fonction des perturbations appliquées, en cas de stabilité (figure 3A) et d'instabilité (figure 3B) du système électrique ;
La figure 4 est un exemple d'entrelacement des fréquences balayées par une séquence de perturbations.

## EXPOSÉ DÉTAILLÉ D'UN MODE DE RÉALISATION PRÉFÉRÉ

Le système électrique est, dans la suite de la description, une pile à combustible du type à membrane échangeuse de protons.

Le système électrique n'est cependant pas limité à une pile à combustible, mais peut être un électrolyseur, une batterie primaire ou rechargeable, tout autre type de dispositif électrochimique, ainsi que tout système électrique qui peut recevoir ou débiter de l'énergie électrique.

La pile à combustible est connectée à un dispositif de puissance permettant d'imposer un courant électrique, tel qu'une charge active ou un convertisseur statique d'interface avec une application. La charge active présente une bande passante couvrant au moins la suite de fréquences à étudier.

La pile est connectée à un dispositif d'analyse d'impédance. Celui-ci peut être un analyseur d'impédance commercial, un ordinateur comportant des cartes synchrones de génération et d'acquisition de courant et/ou de tension embarquable ou non.

Une séquence de perturbations sinusoïdales de courant est appliquée à la pile à combustible, autour d'un point de polarisation.

Le point de polarisation reste, de préférence, constant tout le long de l'application de la séquence de perturbations.

Chaque perturbation comprend, de préférence, quelques périodes pour que s'amortisse un éventuel régime transitoire, puis quelques périodes pour le calcul de l'impédance.

Chaque perturbation a une fréquence différente, de sorte que la séquence de perturbation balaye une suite principale A de fréquences A = { $f_1$, $f_2$, ..., $f_N$}. Plus précisément, la séquence de perturbations comporte au moins une perturbation pour chaque fréquence de la suite A.

La gamme de la suite principale A de fréquences peut aller de quelques millihertz à quelques dizaines de kilohertz, et comprend N fréquences à balayer, par exemple, une centaine de fréquences.

L'amplitude des perturbations est suffisamment faible pour que la réponse de la pile reste linéaire. Pour cela, l'amplitude est sensiblement inférieure à 10% de la valeur du courant au point de fonctionnement considéré, et est préférentiellement de l'ordre du pourcent de cette valeur.

Un dispositif d'analyse d'impédance donne l'impédance complexe de la pile pour chacune des fréquences de la suite principale A. Il est alors possible de tracer l'évolution de la partie imaginaire de l'impédance en fonction de la partie réelle dans un plan de Nyquist.

Il est à noter que, dans le cas où le signal d'entrée est la tension aux bornes de la pile, le dispositif d'analyse d'impédance déduit l'admittance complexe de la pile, et non plus l'impédance complexe. L'impédance peut néanmoins être aisément déduite de l'admittance.

Selon l'invention, les fréquences de ladite suite principale A sont distribuées de manière à former une pluralité de sous-suites $A^1$,..., $A^n$ de fréquences.

Par sous-suite $(A^1)_{i=1...n}$ de fréquences, on entend un ensemble de fréquences extraites, ou issues, de la suite principale A :

$$A^i = \left\{ f_j^i \, / \, f_j^i \in A \right\}$$

La réunion des sous-suites $(A^1)_{i=1...n}$ correspond à la suite principale A de fréquences :

$$A = \bigcup_{i=1}^{n} A^i$$

De préférence, chaque sous-suite ne contient pas de fréquences en commun avec une autre sous-suite :

$$\bigcap_{i=1}^{n} A^i = \varnothing$$

De préférence, chaque sous-suite $(A^i)_{i=1...n}$ de fréquences comporte $N^i$ fréquences, de sorte que la somme des $N^i$ fréquences égale le nombre N de fréquences de la suite principale A :

$$\sum_{i=1}^{n} N^i = N$$

Chaque sous-suite $A^i$ présente une gamme de fréquences. Par gamme $G^i$ de la sous-suite $A^i$, on entend l'ensemble des fréquences de la sous-suite considérée comprises entre la plus haute fréquence et la plus basse fréquence de ladite sous-suite. Ainsi :

$$G^i = \left\{ f_j^i \, / \, \forall j \in \left[ 1, N^i \right], f_{(min)}^i \leq f_j^i \leq f_{(max)}^i \right\}$$

avec

$$f^i_{(min)} = \min\left(A_i\right) \qquad f^i_{(max)} = \max\left(A_i\right)$$

Chaque sous-suite $A^i$ de ladite pluralité de sous-suites est entrelacée avec au moins une autre sous-suite $A^{i'}$ de la même pluralité.

Par entrelacement de deux sous-suites $A^i$ et $A^{i'}$, on entend la présence d'au moins une fréquence d'une première sous-suite entre deux fréquences consécutives de la deuxième sous-suite.

Plus précisément, il y a entrelacement entre les sous-suites $A^i$ et $A^{i'}$ telles que

$$A^i = \left\{f^i_j\right\}_{j\in\left[1,N^i\right]} \qquad et \qquad A^{i'} = \left\{f^{i'}_k\right\}_{k\in\left[1,N^{i'}\right]}$$

si :

$$\exists j_0 \,/\, f^{i'}_k \leq f^i_{j_0} \leq f^{i'}_{k+1}$$

ou si :

$$\exists k_0 \,/\, f^i_j \leq f^{i'}_{k_0} \leq f^i_{j+1}$$

Dans le premier mode de réalisation de l'invention, chaque sous-suite est entrelacée avec toutes les autres sous-suites de ladite pluralité.

Chaque sous-suite est parcourue par la séquence de perturbations de manière monotone, dans la même direction, de préférence des hautes fréquences vers les basses fréquences.

De plus, ladite pluralité de sous-suites de fréquences est parcourue de manière monotone. Par ordre monotone, on entend que la pluralité de sous-suites de fréquences est parcourue de sous-suite en sous-suite voisine, suivant un classement ordonné des sous-suites. De préférence, lesdites sous-suites sont classées suivant l'ordre décroissant de la fréquence maximale de chaque sous-suite.

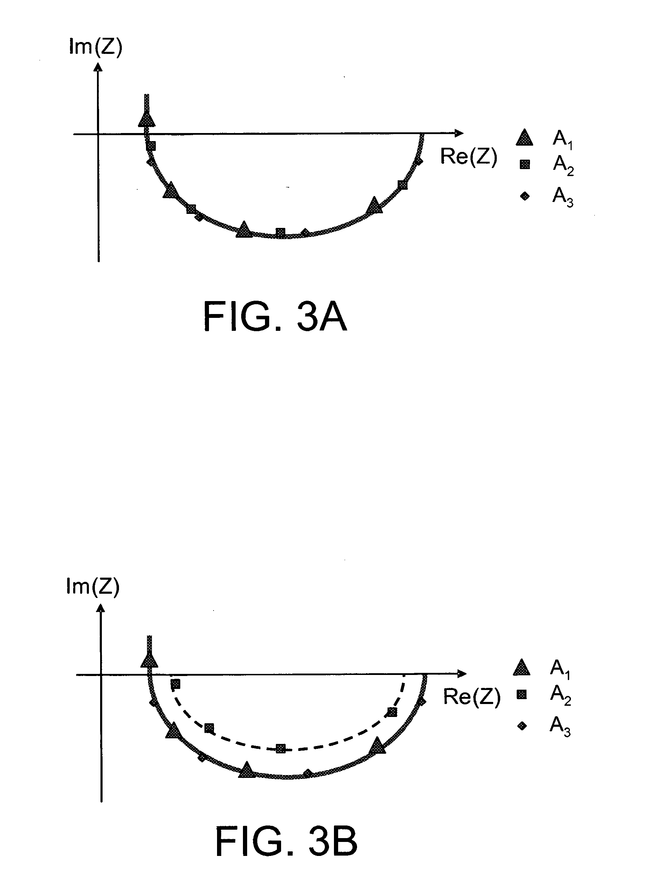

A titre d'exemple, et comme l'illustrent les figures 3A et 3B, la suite principale A de fréquences à balayer est de 2Hz à 10kHz, et comporte 12 fréquences. Aussi, la suite A est : A = {10kHz, 5kHz, 2kHz, 1kHz, 500Hz, 200Hz, 100Hz, 50Hz, 20Hz, 10Hz, 5Hz, 2Hz}.

Trois sous-suites $A^1$, $A^2$, $A^3$ sont formées à partir de la suite principale A par décimation d'une fréquence sur trois :

A¹ = {10kHz, 1kHz, 100Hz, 10Hz}
A² = {5kHz, 500Hz, 50Hz, 5Hz}
A³ = {2kHz, 200Hz, 20Hz, 2Hz}

Selon ce mode de réalisation, chaque sous-suite de fréquences présente au moins une fréquence comprise entre deux fréquences consécutives d'une autre sous-suite. Il y a donc entrelacement entre chacune des trois sous-suites, et non pas seulement entre deux sous-suites voisines.

Ainsi, au lieu d'appliquer la séquence de perturbations de manière à balayer continûment les N fréquences de la suite principale A, comme dans la solution classique de l'art antérieur décrite précédemment, la séquence de perturbations parcourt tour à tour les trois sous-suites de fréquences.

La séquence de perturbations parcourt successivement, de préférence, les fréquences de la sous-suite $A^1$ puis celles de la sous-suite $A^2$ etc.

Ainsi, en entrelaçant lesdites sous-suites, le procédé permet de savoir rapidement si le système est resté stable pendant la durée des mesures.

En effet, en cas d'instabilité de la pile à combustible, dès l'application de la sous-suite $A^i$, les points expéri-

mentaux de l'impédance pour les fréquences de cette sous-suite ne se situent pas dans la continuité des points correspondant à l'impédance mesurée pour la sous-suite précédente $A^{i-1}$.

Par exemple, comme l'illustrent les figures 3A et 3B, l'application des perturbations balayant la sous-suite $A^1$ permet d'obtenir les valeurs de l'impédance $Z(A^1)$ pour les fréquences considérées : $Z(10kHz)$, $Z(1kHz)$, $Z(100Hz)$...

Les valeurs de l'impédance $Z(A^2)$ pour les fréquences de la sous-suite $A^2$ devraient, si la pile était restée stable le temps de la mesure, se placer en continuité avec celles de $Z(A^1)$. Comme le montre la figure 3A (pile stable), les valeurs de l'impédance pour chaque sous-suite de fréquences se placent continûment le long d'une courbe donnée (trait continu).

Si la pile devient instable entre les sous-suites $A^1$ et $A^2$, une discontinuité apparaît entre $Z(A^1)$ et $Z(A^2)$ dans la zone de recouvrement entre les gammes de ces deux sous-suites. La figure 3B illustre cette discontinuité. Les valeurs de $Z(A^2)$ se placent sur une courbe (trait en pointillé) différente de celle de $Z(A^1)$ (trait continu). La discontinuité apparaît dès la première valeur de $Z(A^2)$ correspondant à la première fréquence appliquée de la sous-suite $A^2$.

On peut évaluer simplement la discontinuité dans la zone de recouvrement considérée. Ainsi, une première fréquence $f^1_i$ d'une première sous-suite $A^1$ est située entre deux fréquences consécutives $f^2_j$ et $f^2_{j+1}$ d'une seconde sous-suite $A^2$. Les première et seconde sous-suites $A^1$ et $A^2$ sont donc entrelacées.

On calcule une valeur de l'impédance pour la première fréquence $Z_{int}(f^1_i)$ à partir des impédances correspondant aux deux fréquences $Z(f^2_j)$ et $Z(f^2_{j+1})$ de la seconde sous-suite. Ce calcul peut être réalisé, par exemple, par interpolation linéaire, cubique (par spline cubique) ou polynomiale.

On calcule ensuite un écart entre la valeur de l'impédance estimée pour une première fréquence $Z(f^1_i)$ et la valeur de l'impédance obtenue par interpolation $Z_{int}(f^1_i)$.

On compare enfin l'écart calculé à un écart seuil prédéterminé. Lorsque cet écart dépasse l'écart seuil, on en déduit une instabilité de la pile à combustible.

Ainsi, la séquence de perturbations permet de savoir rapidement si le système est resté stable pendant la durée des mesures.

De plus, le fait de solliciter à nouveau les hautes fréquences, ici en début de chaque sous-suite, permet de repérer d'éventuels phénomènes physiques rapides tout au long de la mesure.

Bien entendu, cet exemple n'est donné qu'à titre illustratif. Il est possible d'augmenter ou de diminuer le nombre de sous-suites, et donc de diminuer respectivement ou d'augmenter le nombre de fréquences dans chaque sous-suite.

Par exemple, pour une suite principale A comportant 400 fréquences, la séquence de perturbations peut parcourir une vingtaine de sous-suites de fréquences comportant chacune une vingtaine de fréquences.

Selon un deuxième mode de réalisation de l'invention, chaque sous-suite $A^i$ de fréquences n'est entrelacée qu'avec la ou les sous-suite(s) voisine(s) $A^{i-1}$ et $A^{i+1}$. A l'exception de cette différence, le deuxième mode de réalisation reste similaire au premier mode.

A titre d'exemple, pour la suite principale suivante A = {10kHz, 5kHz, 2kHz, 1kHz, 500Hz, 200Hz, 100Hz, 50Hz, 20Hz, 10Hz, 5Hz, 2Hz}, les sous-suites peuvent être :

$A^1$ = {10kHz, 2kHz}
$A^2$ = {5kHz, 500Hz}
$A^3$ = {1kHz, 100Hz}
$A^4$ = {200Hz, 20Hz}
$A^5$ = {50Hz, 5Hz}
$A^6$ = {10Hz, 2Hz}

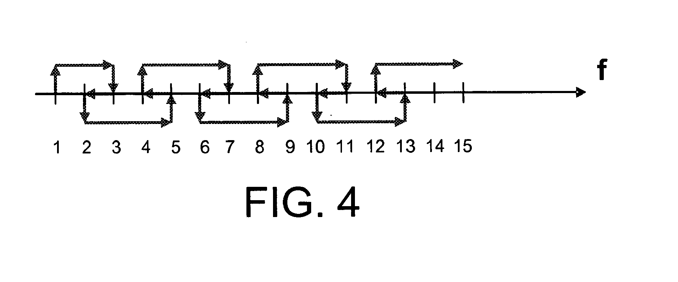

La séquence de perturbations balaie les sous-suites tour à tour, suivant l'ordre décroissant des fréquences maximales, comme sur la figure 4 qui illustre un exemple d'entrelacement des fréquences pour le deuxième mode de réalisation de l'invention.

Ainsi, la séquence des perturbations présente un mouvement présentant une succession d'allers-retours, tout en allant progressivement des hautes fréquences vers les basses fréquences.

Comme décrit précédemment, en cas d'instabilité de la pile, une discontinuité dans les valeurs de l'impédance apparaît au niveau des zones de recouvrement entre sous-suites voisines.

Cette discontinuité peut être exploitée pour diagnostiquer une défaillance naissante, comme par exemple un assèchement ou un engorgement d'une pile à combustible, et conduire à une rétroaction sur le contrôle-commande de la pile à combustible.

Pour les différents modes de réalisation décrits précédemment, les fréquences de chaque sous-suite $A^i$ peuvent être balayées, non plus de manière monotone, mais aléatoire, par ladite séquence de perturbations.

De la même manière, ladite pluralité de sous-suites de fréquences $A^1$, ..., $A^n$ peut être parcourue de manière aléatoire par ladite séquence de perturbations.

Il est à noter qu'une spectroscopie entrelacée, quels que soient les modes de réalisation décrits précédemment, présente un résultat identique, lorsque la pile reste stable, à celui d'une spectroscopie classique.

**Revendications**

1. Procédé de caractérisation d'un système électrique comportant des étapes consistant à :

   - appliquer audit système électrique un signal d'entrée comportant une séquence de perturbations sinusoïdales de courant ou de tension, autour d'un point de polarisation dudit système électrique, chaque perturbation ayant une fréquence différente appartenant à une suite principale (A) de fréquences,
   - mesurer un signal de sortie dudit système électrique en réponse audit signal d'entrée pour chacune desdites perturbations appliquées,
   - estimer une grandeur caractéristique de l'impédance dudit système électrique pour chacune desdites perturbations appliquées, l'ensemble desdites estimations de la grandeur caractéristique de l'impédance caractérisant ledit système électrique, les perturbations de ladite séquence étant appliquées de manière à balayer tour à tour une pluralité de sous-suites ($A^1$, ..., $A^n$), chacune desdites sous-suites ($A^1$, ..., $A^n$) étant un ensemble de fréquences issues de la suite principale (A), chaque sous-suite de ladite pluralité de sous-suites étant entrelacée avec au moins une autre sous-suite de la même pluralité de sorte qu'elle comporte au moins une fréquence comprise entre deux fréquences consécutives de ladite autre sous-suite avec laquelle elle est entrelacée, le procédé étant **caractérisé en ce que** l'intersection desdites sous-suites est égale à l'ensemble vide.

2. Procédé selon la revendication 1, **caractérisé en ce que** chaque sous-suite de ladite pluralité est entrelacée avec toutes les autres sous-suites de la même pluralité.

3. Procédé selon l'une quelconque des revendications 1 ou 2, **caractérisé en ce que** les perturbations de ladite séquence sont appliquées de manière à balayer de manière monotone les fréquences de chaque sous-suite ($A^i$).

4. Procédé selon l'une quelconque des revendications 1 ou 2, **caractérisé en ce que** les perturbations de ladite séquence sont appliquées de manière à balayer de manière aléatoire les fréquences de chaque sous-suite ($A^i$).

5. Procédé selon l'une quelconque des revendications 1 à 4, **caractérisé en ce que** les sous-suites sont classées suivant un ordre déterminé, les perturbations de ladite séquence étant appliquées de manière à balayer de manière monotone lesdites sous-suites ($A^1$, ..., $A^n$) de ladite pluralité.

6. Procédé selon l'une quelconque des revendications 1 à 4, **caractérisé en ce que** les sous-suites sont classées suivant un ordre déterminé, les perturbations de ladite séquence étant appliquées de manière à balayer de manière aléatoire lesdites sous-suites ($A^1$,...,$A^n$) de ladite pluralité.

7. Procédé selon l'une quelconque des revendications 1 à 6, **caractérisé en ce qu'**il comporte les étapes ultérieures consistant à :

   - calculer un écart entre l'estimation de ladite grandeur caractéristique de l'impédance pour une première fréquence d'une première sous-suite de ladite pluralité de sous-suites d'une part, et une valeur obtenue par interpolation, pour la même première fréquence, des estimations de ladite grandeur caractéristique pour deux fréquences consécutives d'une seconde sous-suite de la même pluralité d'autre part, entre lesquelles ladite première fréquence est située ;
   - détecter une instabilité du système électrique lorsque ledit écart calculé dépasse un écart seuil prédéterminé.

8. Procédé selon l'une quelconque des revendications précédentes, **caractérisé en ce que** ledit système électrique est une pile à combustible.

9. Procédé de commande d'un système électrique, **caractérisé en ce qu'**il comporte :

   - la mise en oeuvre du procédé de caractérisation selon l'une quelconque des revendications précédentes, pour caractériser ledit système électrique par l'ensemble desdites estimations de la grandeur caractéristique de l'impédance ; puis
   - la mesure d'un écart entre au moins l'une desdites estimations de la grandeur caractéristique de l'impédance dudit système électrique et au moins une valeur de référence de ladite grandeur ; puis
- l'application d'une commande audit système électrique lorsque ledit écart mesuré dépasse un écart seuil prédéterminé.

**Patentansprüche**

1. Verfahren zur Charakterisierung eines elektrischen Systems, umfassend die folgenden Schritte:

   - Anlegen eines Eingangssignals, das eine Sequenz von sinusförmigen Strom- oder Spannungsstörungen umfasst, an das elektrische System um einen Polarisationspunkt des elektrischen Systems herum, wobei jede Störung eine unterschiedliche Frequenz hat, die zu einer Hauptfolge (A) von Frequenzen gehört,
   - Messen eines Ausgangssignals des elektrischen Systems in Antwort auf das Eingangssignal für jede der angelegten Störungen,
   - Abschätzen einer charakteristischen Größe der Impedanz des elektrischen Systems für jede der angelegten Störungen, wobei die Gesamtheit der Abschätzungen der charakteristischen Größe der Impedanz das elektrische System charakterisiert, wobei die Störungen der Sequenz derart angelegt werden, dass sie der Reihe nach eine Mehrzahl von Unterfolgen ($A^1$, ..., $A^n$) überstreichen, wobei jede der Unterfolgen ($A^1$, ..., $A^n$) eine Gesamtheit von Frequenzen ist, die aus der Hauptfolge (A) hervorgehen, wobei jede Unterfolge der Mehrzahl von Unterfolgen mit wenigstens einer anderen Unterfolge der gleichen Mehrzahl derart verschachtelt ist, dass sie wenigstens eine Frequenz enthält, die zwischen zwei aufeinanderfolgenden Frequenzen der anderen Unterfolge enthalten ist, mit der sie verschachtelt ist,
   wobei das Verfahren **dadurch gekennzeichnet ist, dass** die Schnittmenge der Unterfolgen gleich der leeren Menge ist.

2. Verfahren nach Anspruch 1, **dadurch gekennzeichnet, dass** jede Unterfolge der Mehrzahl mit allen anderen Unterfolgen der gleichen Mehrzahl verschachtelt ist.

3. Verfahren nach einem der Ansprüche 1 oder 2, **dadurch gekennzeichnet, dass** die Störungen der Sequenz derart angelegt werden, dass sie in monotoner Weise die Frequenzen jeder Unterfolge ($A^i$) überstreichen.

4. Verfahren nach einem der Ansprüche 1 oder 2, **dadurch gekennzeichnet, dass** die Störungen der Sequenz derart angelegt werden, dass sie in zufälliger Weise die Frequenzen jeder Unterfolge ($A^i$) überstreichen.

5. Verfahren nach einem der Ansprüche 1 bis 4, **dadurch gekennzeichnet, dass** die Unterfolgen gemäß einer bestimmten Ordnung klassifiziert sind, wobei die Störungen der Sequenz derart angelegt werden, dass sie in monotoner Weise die Unterfolgen ($A^1$, ..., $A^n$) der Mehrzahl überstreichen.

6. Verfahren nach einem der Ansprüche 1 bis 4, **dadurch gekennzeichnet, dass** die Unterfolgen gemäß einer bestimmten Ordnung klassifiziert sind, wobei die Störungen der Sequenz derart angelegt werden, dass sie in zufälliger Weise die Unterfolgen ($A^1$, ..., $A^n$) der Mehrzahl überstreichen.

7. Verfahren nach einem der Ansprüche 1 bis 6, **dadurch gekennzeichnet, dass** es die folgenden weiteren Schritte umfasst:

   - Berechnen eines Abstands zwischen der Abschätzung der für die Impedanz charakteristischen Größe für eine erste Frequenz einer ersten Unterfolge der Mehrzahl von Unterfolgen einerseits, und einem Wert, der erhalten ist durch Interpolation für die gleiche erste Frequenz der Abschätzungen der Größe, die charakteristisch ist für zwei aufeinanderfolgende Frequenzen einer zweiten Unterfolge der gleichen Mehrzahl andererseits, zwischen denen die erste Frequenz gelegen ist;
   - Erfassen einer Instabilität des elektrischen Systems, wenn der berechnete Abstand einen vorbestimmten Schwellenabstand übersteigt.

8. Verfahren nach einem der vorhergehenden Ansprüche, **dadurch gekennzeichnet, dass** das elektrische System eine Brennstoffzelle ist.

9. Verfahren zur Steuerung eines elektrischen Systems, **dadurch gekennzeichnet, dass** es umfasst:

- die Durchführung des Verfahrens zur Charakterisierung nach einem der vorhergehenden Ansprüche, um das elektrische System durch die Gesamtheit der Abschätzungen der für die Impedanz charakteristischen Größe zu charakterisieren; und dann
- das Messen eines Abstands zwischen wenigstens einer der Abschätzungen der für die Impedanz des elektrischen Systems charakteristischen Größe und wenigstens einem Referenzwert der Größe; und dann
- die Anwendung einer Steuerung auf das elektrische System, wenn der gemessene Abstand einen vorbestimmten Schwellenabstand übersteigt.

**Claims**

1. A method for characterizing an electrical system including the following steps:

   - applying an input signal to said electrical system that comprises a sequence of sinusoidal current or voltage perturbations, around a polarization point of said electrical system, each perturbation having a different frequency belonging to a primary series (A) of frequencies;
   - measuring an output signal of said electrical system in response to said input signal for each of said applied perturbations;
   - estimating a characteristic variable of the impedance of said electrical system for each of said applied perturbations, the set of said estimates of the characteristic variables of the impedance characterizing said electrical system;
   the perturbations of said sequence being applied so as to scan, turn by turn, a plurality of sub-series ($A^1$, ..., $A^n$) of frequencies resulting from said primary series (A), each sub-series of said plurality being interleaved with at least one other sub-series of the same plurality, so that it comprises at least one frequency between two consecutive frequencies of the second sub-series with it is interleaved;
   the method being **characterized in that** the intersection between said sub-series is void.

2. The method according to claim 1, **characterized in that** each sub-series of said plurality is interleaved with all of the other sub-series of the same plurality.

3. The method according to any one of claims 1 or 2, **characterized in that** the perturbations of said sequence are applied so as to monotonously or randomly scan the frequencies of each sub-series ($A^i$).

4. The method according to any one of claims 1 or 2, **characterized in that** the perturbations of said sequence are applied so as to randomly scan the frequencies of each sub-series ($A^i$).

5. The method according to any one of claims 1 to 4, **characterized in that** the sub-series are ranked according to a predetermined order, the perturbations of said sequence being applied so as to monotonously scan said sub-series ($A^1$, ..., $A^n$) of said plurality.

6. The method according to any one of claims 1 to 4, **characterized in that** the sub-series are ranked according to a predetermined order, the perturbations of said sequence being applied so as to randomly scan said sub-series ($A^1$, ..., $A^n$) of said plurality.

7. The method according to any one of claims 1 to 6, **characterized in that** it includes the subsequent steps consisting of:

   - calculating a deviation between the estimate of said characteristic variable of the impedance for a first frequency of a first sub-series of said plurality of sub-series on the one hand, and a value obtained by interpolation, for the same first frequency, of the estimates of said characteristic variable for two consecutive frequencies of a second sub-series of the same plurality on the other hand, between which said first frequency is situated;
   - detecting an instability of the electrical system when said calculated deviation exceeds a predetermined threshold deviation.

8. The method according to any one of the preceding claims, **characterized in that** said electrical system is a fuel cell.

9. A method for controlling an electrical system, including:

   - performing the characterization method according to any one of the preceding claims, to characterize said electrical system by the set of said estimates of the characteristic variable of the impedance; then
- measuring a deviation between at least one of said estimates of the characteristic variable of the impedance of said electrical system and at least one reference value of said variable; then
- applying a command to said electrical system when said measured deviation exceeds a predetermined threshold deviation.

# FIG. 1

# FIG. 2

FIG. 3A

FIG. 3B

FIG. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **FOUQUET et al.** Model based PEM fuel cell state-of-health monitoring via ac impedance measurements. *Journal of Power Sources,* 2006, vol. 159, 905-913

- **X. YUAN et al.** AC Impedance technique in PEM fuel cell diagnoses- A review. *International Journal of Hydrogen Energy,* 2007, vol. 32, 4365-4380